# EUROPEAN PATENT APPLICATION

(11) **EP 4 647 791 A2**
(43) Date of publication of application: **12.11.2025**
(21) Application number: 25204307.0
(22) Date of filing: 12.12.2023
(51) Int. Cl.: G01R 31/392

(54) **APPARATUS AND METHOD FOR DIAGNOSING BATTERY**

(30) Priority: 12.12.2022 KR 20220172880; 11.12.2023 KR 20230179139
(62) Divisional of application: 23892785.9
(71) Applicant: LG Energy Solution, Ltd., Seoul 07335 (KR)
(72) Inventor: KIM, Ki-Hoon, 34122 Daejeon (KR); PARK, Han-Gon, 34122 Daejeon (KR); SONG, Chang-Yong, 34122 DAEJEON (KR); LEE, Bo-Kyun, 34122 DAEJEON (KR); KIM, Cheol-Taek, 34122 DAEJEON (KR); KIM, Ji-Yong, 34122 DAEJEON (KR)
(74) Representative: Plasseraud IP

(57) **Abstract**

An apparatus for diagnosing a battery according to an embodiment of the present disclosure includes a voltage measuring unit configured to measure voltages of a plurality of batteries; and a control unit configured to calculate a voltage deviation of the plurality of batteries, calculate a voltage deviation variation of each of the plurality of batteries at each predetermined period, and compare a pattern of the voltage deviation variation of each of the plurality of batteries with a preset diagnosis pattern to diagnose a state of each of the plurality of batteries.

## Description

### TECHNICAL FIELD

The present application claims priority to Korean Patent Application No. 10-2022-0172880 filed on December 12, 2022 in the Republic of Korea and Korean Patent Application No. 10-2023-0179139 filed on December 11, 2023 in the Republic of Korea, the disclosures of which are incorporated herein by reference.

The present disclosure relates to an apparatus and method for diagnosing a battery, and more particularly, to an apparatus and method for diagnosing a battery, which is capable of diagnosing an internal micro short circuit of the battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density. Memory effect is a loss of energy capacity in a rechargeable battery resulting from charging the battery when it is partially discharged.

An energy storage system using such a battery may be a device that stores large-scale power and provides the stored power to a plurality of load facilities. For example, the energy storage system is used in the form of an industrial, building, or household energy management system, and is used as a regular power grid and/or an emergency power grid by providing the stored power to load facilities at each point of use.

When a micro short circuit occurs inside the battery, there is a problem that leakage current of the battery occurs. For example, it is assumed that a plurality of batteries are included in a battery pack. If leakage current occurs due to an internal micro short circuit in a battery, the voltage of the battery may gradually become lower than that of other batteries. Also, if the micro short circuit continues, a hard short circuit may occur and permanent damage may be applied to the battery pack. A hard short (or dead short) may occur when the voltage difference between a plurality of batteries in the battery pack continues to increase. The hard short (or dead short) may cause a surge of current within the battery pack, which may lead to sparks, overheating, circuit damage, or the like.

For example, if the voltage difference between the plurality of batteries continue to increase, then an inrush current (or overcurrent) may flow inside of the battery pack. Inrush currents may generate heat and, consequently, may cause the hard short. Further, inrush currents may cause permanent damage to the circuitry within the battery pack.

Therefore, it is necessary to develop a technology capable of diagnosing in advance whether a micro short circuit has occurred inside the battery.

### DISCLOSURE

### Technical Problem

The present disclosure is designed to solve the problems of the related art, and therefore the present disclosure is directed to providing an apparatus and method for diagnosing a battery, which is capable of diagnosing whether an internal micro short circuit occurs in the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a voltage measuring unit configured to measure voltages of a plurality of batteries; and a control unit configured to calculate a voltage deviation of the plurality of batteries, calculate a voltage deviation variation of each of the plurality of batteries at each predetermined period, and compare a pattern of the voltage deviation variation of each of the plurality of batteries with a preset diagnosis pattern to diagnose a state of each of the plurality of batteries.

The control unit may be configured to diagnose a state of a corresponding battery based on at least one of sum, magnitude and increase pattern of a plurality of voltage deviation variations calculated at a plurality of time points for each of the plurality of batteries.

The diagnosis pattern may include at least one of a first diagnosis pattern corresponding to the sum of the plurality of voltage deviation variations, a second diagnosis pattern corresponding to the magnitude of each of the plurality of voltage deviation variations, a third diagnosis pattern corresponding to the maximum magnitude of the plurality of voltage deviation variations, and a fourth diagnosis pattern corresponding to the increase pattern of the plurality of voltage deviation variations.

The control unit may be configured to diagnose that an internal micro short circuit has occurred in the battery when the pattern of the plurality of voltage deviation variations corresponds to at least one of the diagnosis patterns.

When the plurality of voltage deviation variations are positive numbers and the sum of the plurality of voltage deviation variations is greater than or equal to a preset first criterion value, the control unit may be configured to judge that the pattern of the voltage deviation variation corresponds to the first diagnosis pattern and diagnose that an internal micro short circuit has occurred in the battery.

When the plurality of voltage deviation variations are greater than or equal to a preset second criterion value, the control unit may be configured to judge that the pattern of the voltage deviation variation corresponds to the second diagnosis pattern and diagnose that an internal micro short circuit has occurred in the battery.

When the plurality of voltage deviation variations are positive numbers and at least one of the plurality of voltage deviation variations is greater than or equal to a preset third criterion value, the control unit may be configured to judge that the pattern of the voltage deviation variation corresponds to the third diagnosis pattern and diagnose that an internal micro short circuit has occurred in the battery.

The third criterion value may be configured to be less than a preset first criterion value to correspond to the first diagnosis pattern and to exceed a preset second criterion value to correspond to the second diagnosis pattern.

When the plurality of voltage deviation variations are positive numbers and the plurality of voltage deviation variations increase over time, the control unit may be configured to judge that the pattern of the voltage deviation variation corresponds to the fourth diagnosis pattern and diagnose that an internal micro short circuit has occurred in the battery.

When the plurality of voltage deviation variations are positive numbers, the control unit may be configured to compare the pattern of the voltage deviation variation of the corresponding battery with a preset diagnosis pattern.

The control unit may be configured to calculate an average voltage of the plurality of batteries and calculate a voltage deviation of each of the plurality of batteries by calculating a difference between the calculated average voltage and the voltage of each of the plurality of batteries.

The control unit may be configured to transmit at least one signal to an external device, the signal containing a diagnosis result of each of the plurality of batteries.

The external device may correspond to any one of an onboard vehicle system, an external vehicle system, one or more servers configured to communicate with a vehicle, or a mobile device configured to communicate with the vehicle.

A battery pack according to another aspect of the present disclosure may comprise comprising the apparatus for diagnosing a battery according to one aspect of the present disclosure.

A vehicle according to still another aspect of the present disclosure may comprise comprising the apparatus for diagnosing a battery according to one aspect of the present disclosure.

A method for diagnosing a battery according to still another aspect of the present disclosure may comprise a voltage measuring step of measuring voltages of a plurality of batteries; a voltage deviation calculating step of calculating a voltage deviation of the plurality of batteries; a voltage deviation variation calculating step of calculating a voltage deviation variation of each of the plurality of batteries at each predetermined period; and a diagnosing step of comparing a pattern of the voltage deviation variation of each of the plurality of batteries with a preset diagnosis pattern to diagnose a state of each of the plurality of batteries.

### Advantageous Effects

According to one aspect of the present disclosure, the apparatus for diagnosing a battery can diagnose the state of each battery by tracking the trend in a voltage deviation variation of the battery at every predetermined period.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically illustrating an apparatus for diagnosing a battery according to an embodiment of the present disclosure.
FIG. 2 is a diagram schematically illustrating voltages for a plurality of battery cells according to an embodiment of the present disclosure.
FIG. 3 is a diagram schematically showing a voltage deviation variation according to an embodiment of the present disclosure.
FIGS. 4 and 5 are diagrams schematically showing an embodiment of a first diagnosis pattern.
FIGS. 6 and 7 are diagrams schematically showing an embodiment of a second diagnosis pattern.
FIGS. 8 and 9 are diagrams schematically showing an embodiment of a third diagnosis pattern.
FIGS. 10 and 11 are diagrams schematically showing an embodiment of a fourth diagnosis pattern.
FIG. 12 is a diagram showing an exemplary configuration of a battery pack according to another embodiment of the present disclosure.
FIG. 13 is a diagram schematically showing a vehicle according to still another embodiment of the present disclosure.
FIG. 14 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

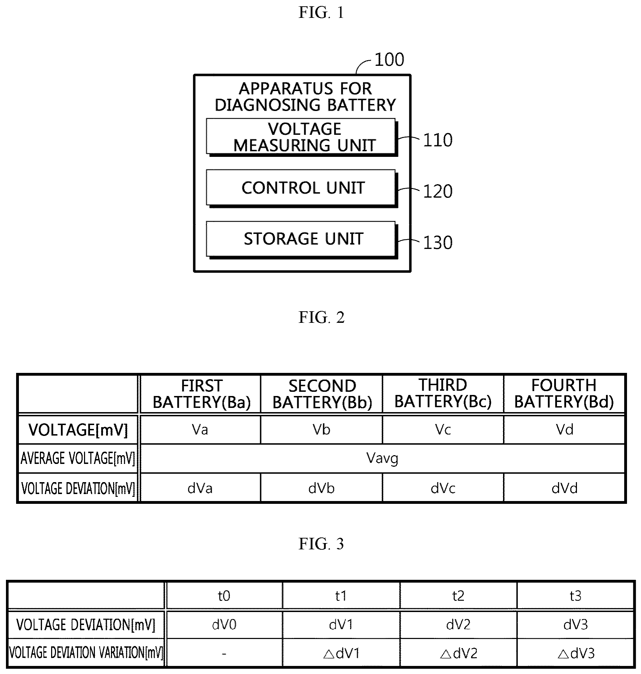

FIG. 1 is a diagram schematically illustrating an apparatus 100 for diagnosing a battery according to an embodiment of the present disclosure.

Referring to FIG. 1, the apparatus 100 for diagnosing a battery may include a voltage measuring unit 110 and a control unit 120.

Here, the battery means one physically separable independent cell having a negative electrode terminal and a positive electrode terminal. For example, a lithium-ion battery or a lithium polymer battery may be regarded as a battery. Hereinafter, for convenience of description, a battery will be described as meaning one independent cell.

The voltage measuring unit 110 may be configured to measure the voltage of a plurality of batteries.

Specifically, the voltage measuring unit 110 may be configured to measure the voltage of each of the plurality of batteries.

FIG. 2 is a diagram schematically illustrating voltages for a plurality of battery cells according to an embodiment of the present disclosure.

In the embodiment of FIG. 2, it is assumed that a first battery Ba, a second battery Bb, a third battery Bc, and a fourth battery Bd are provided. The voltage measuring unit 110 may measure the voltage of the first battery Ba as Va, measure the voltage of the second battery Bb as Vb, measure the voltage of the third battery Bc as Vc, and measure the voltage of the fourth battery Bd as Vd.

Also, the voltage measuring unit 110 may be communicatively connected to the control unit 120. For example, the voltage measuring unit 110 and the control unit 120 may be connected wired and/or wirelessly. The voltage measuring unit 110 may transmit information about the measured voltage to the control unit 120.

The control unit 120 may be configured to calculate a voltage deviation of the plurality of batteries.

Specifically, the control unit 120 may receive voltage information of the plurality of batteries from the voltage measuring unit 110 and calculate a voltage deviation of the plurality of batteries based on the received voltage information.

First, the control unit 120 may be configured to calculate an average voltage of a plurality of batteries. In the embodiment of FIG. 2, the control unit 120 may calculate an average voltage for voltages of the first to fourth batteries Ba, Bb, Bc, Bd. For example, the control unit 120 may calculate the average voltage as Vavg by calculating the formula of "(Va+Vb+Vc+Vd)÷4".

The control unit 120 may calculate the average voltage Vavg at predetermined time period, discussed below. As such, the average voltage Vavg corresponding to the t1 time point may be calculated based on a plurality of voltage information for a plurality of batteries obtained at the t1 time point. Similarly, the average voltage Vavg corresponding to the t2 time point may be calculated based on a plurality of voltage information for a plurality of batteries obtained at the t2 time point. Therefore, each time point may correspond to a different average voltage Vavg.

Next, the control unit 120 may be configured to calculate a voltage deviation of each of the plurality of batteries by calculating a difference between the calculated average voltage and the voltage of each of the plurality of batteries. In the embodiment of FIG. 2, the control unit 120 may calculate the voltage deviation of the first to fourth batteries Ba, Bb, Bc, Bd by calculating the difference between the voltage of the first to fourth batteries Ba, Bb, Bc, Bd and the average voltage. For example, the control unit 120 may calculate the voltage deviation of the first battery Ba as dVa by calculating the formula of "|Va-Vavg|" and calculate the voltage deviation of the second battery Bb as dVb by calculating the formula of "|Vb-Vavg|". Also, the control unit 120 may calculate the voltage deviation of the third battery Bc as dVc by calculating the formula of "|Vc-Vavg|", and calculate the voltage deviation of the fourth battery Bd as dVd by calculating the formula of "|Vd-Vavg|". Here, "||" is an absolute value symbol, and the calculated voltage deviation can be expressed as an absolute value of the difference between the battery voltage and the average voltage.

The control unit 120 may be configured to calculate the voltage deviation variation of each of the plurality of batteries at each predetermined period. In some instances, the predetermined time periods may correspond to communication periods in which the control unit 120 and the voltage measuring unit 110 communicate with each other.

Specifically, the control unit 120 may calculate a voltage deviation at each predetermined period for each of the plurality of batteries. Here, the voltage deviation may be a voltage deviation of a plurality of batteries measured in a corresponding period (i.e., a voltage measurement time point of the corresponding period). In addition, the control unit 120 may calculate a voltage deviation variation between the voltage deviation calculated in the previous cycle and the voltage deviation calculated in the current cycle. That is, the control unit 120 may calculate the voltage deviation variation of each of the plurality of batteries at each predetermined period.

FIG. 3 is a diagram schematically showing a voltage deviation variation according to an embodiment of the present disclosure. Specifically, the embodiment of FIG. 3 shows only the voltage deviation of the first battery Ba among the voltage deviations of the first to fourth batteries Ba, Bb, Bc, Bd calculated at t0, t1, t2 and t3 time points. Here, t0, t1, t2, and t3 mean time points determined according to a predetermined period.

Meanwhile, although only the voltage deviation of the first battery Ba is shown in FIG. 3, it should be noted that the voltage deviations of the second to fourth batteries Bb, Bc, Bd are also calculated for diagnosing the state of the second to fourth batteries Bb, Bc, Bd.

In the embodiment of FIG. 3, the voltage deviation of the first battery Ba calculated at the time point t0 is dV0, the voltage deviation of the first battery Ba calculated at the time point t1 is dV1, the voltage deviation of the first battery Ba calculated at the time point t2 is dV2, and the voltage deviation of the first battery Ba calculated at the time point t3 is dV3. The control unit 120 may calculate the difference in voltage deviation at successive time points in order to calculate the voltage deviation variation for the battery at each predetermined period. The control unit 120 may calculate the voltage deviation variation as △dV1 by calculating the difference between the voltage deviations at the t0 time point and the t1 time point according to the formula of "dV1-dV0". The control unit 120 may calculate the voltage deviation variation as △dV2 by calculating the difference between the voltage deviations at the t1 time point and the t2 time point according to the formula of "dV2-dV1". The control unit 120 may calculate the voltage deviation variation as △dV3 by calculating the difference between the voltage deviations at the t3 time point and the t2 time point according to the formula of "dV3-dV2".

The control unit 120 may be configured to diagnose the state of each of the plurality of batteries by comparing a pattern of the voltage deviation variation of each of the plurality of batteries with a preset diagnosis pattern.

Specifically, the control unit 120 may be configured to diagnose the state of a corresponding battery by analyzing a pattern of a plurality of voltage deviation variations calculated for each battery. That is, the control unit 120 calculates the voltage deviation based on the voltages of a plurality of batteries, but the pattern of the voltage deviation variation may be judged based on only the plurality of voltage deviation variations of one battery.

For example, in the embodiment of FIG. 3, the voltage deviations dV0, dV1, dV2, dV3 are values calculated based on the voltages of the plurality of batteries Ba, Bb, Bc, Bd at time points t0, t1, t2 and t3, respectively. On the other hand, the voltage deviation variations △dV1, △dV2, △dV3 are values calculated based on the voltage deviations dV0, dV1, dV2, dV3 of the first battery Ba. That is, the voltage deviation is a value due to the voltages of a plurality of batteries, but the voltage deviation variation is a value due to the voltage deviation of a single battery.

In the embodiment of FIG. 3, the control unit 120 may determine a diagnosis pattern to which the pattern of the voltage deviation variations △dV1, △dV2, △dV3 belongs among preset diagnosis patterns. Also, the control unit 120 may diagnose the state of the first battery Ba to correspond to the determined diagnosis pattern. Similarly, the control unit 120 may diagnose the state of each of the second to fourth batteries Bb, Bc, Bd based on the voltage deviation variation pattern of each of the second to fourth batteries Bb, Bc, Bd.

The apparatus 100 for diagnosing a battery according to an embodiment of the present disclosure may diagnose the state of a single battery by considering both the voltage deviation patterns of a plurality of batteries and the voltage deviation variations of a single battery. That is, the apparatus 100 for diagnosing a battery can individually diagnose the state of each battery by tracking the trend in the voltage deviation variation of the battery at each predetermined period.

Meanwhile, the control unit 120 included in the apparatus 100 for diagnosing a battery may optionally include processors, application-specific integrated circuits (ASIC), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the storage unit 130 may be communicatively connected to the control unit 120. The storage unit 130 may store voltage information of a plurality of batteries measured by the voltage measuring unit 110. In addition, the storage unit 130 may store voltage deviation and voltage deviation variation of a plurality of batteries calculated by the control unit 120 at each predetermined period.

For each of the plurality of batteries, the control unit 120 may be configured to diagnose the state of the corresponding battery based on at least one of sum, magnitude, and increase pattern of the plurality of voltage deviation variations calculated at the plurality of time points.

Specifically, the diagnosis pattern may be configured to include a first diagnosis pattern corresponding to the sum of the plurality of voltage deviation variations, a second diagnosis pattern corresponding to the magnitude of each of the plurality of voltage deviation variations, a third diagnosis pattern corresponding to the maximum magnitude of the plurality of voltage deviation variations, and a fourth diagnosis pattern corresponding to the increase pattern of the plurality of voltage deviation variations.

For example, in the embodiment of FIG. 3, the control unit 120 may diagnose the state of the first battery Ba based on at least one of the sum (△dV1+△dV2+△dV3), magnitude, and increase pattern of the plurality of voltage deviation variations (△dV1, △dV2, △dV3) calculated at the plurality of time points t1, t2, t3 of the first battery Ba.

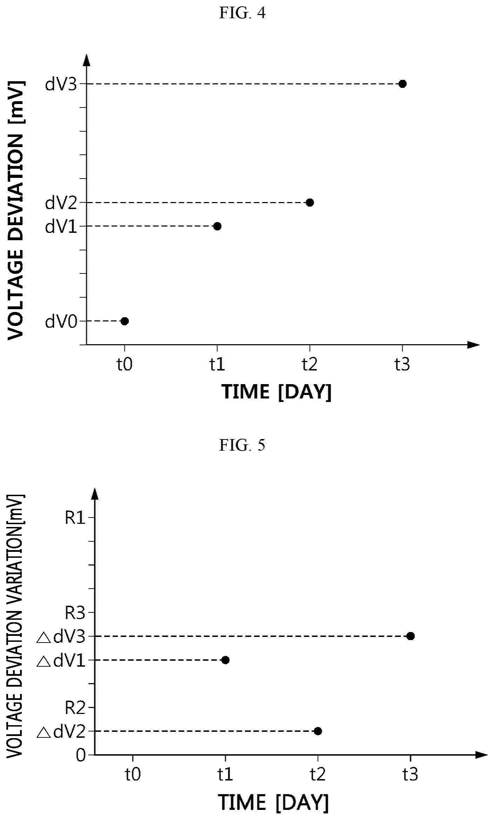

Hereinafter, examples of the diagnosis pattern will be described in detail with reference to FIGS. 4 to 11. For convenience of explanation, △dV1 calculated at t1 time point is called a first voltage deviation variation (△dV1), △dV2 calculated at t2 time point is called a second voltage deviation variation (△dV2), and △dV3 calculated at t3 time point is called a third voltage deviation variation (△dV3).

FIGS. 4 and 5 are diagrams schematically showing an embodiment of a first diagnosis pattern. Specifically, FIG. 4 is a diagram schematically showing an embodiment of the voltage deviation over time of the first diagnosis pattern. FIG. 5 is a diagram schematically showing an embodiment of the voltage deviation variation over time of the first diagnosis pattern based on the FIG. 4.

When the plurality of voltage deviation variations are positive numbers and the sum of the plurality of voltage deviation variations is greater than or equal to a preset first criterion value (R1), the control unit 120 may be configured to judge that the pattern of the voltage deviation variation corresponds to the first diagnosis pattern and diagnose that an internal micro short circuit has occurred in the battery.

For example, in the embodiment of FIG. 5, the first voltage deviation variation (△dV1), the second voltage deviation variation (△dV2), and the third voltage deviation variation (△dV3) may be positive numbers. Also, the sum of the first voltage deviation variation (△dV1), the second voltage deviation variation (△dV2), and the third voltage deviation variation (△dV3) may be greater than or equal to the first criterion value (R1). For example, the first criterion value (R1) may be set to 10 mV. The sum of the first voltage deviation variation (△dV1), the second voltage deviation variation (△dV2) and the third voltage deviation variation (△dV3) may exceed 10 mV.

The control unit 120 may calculate the sum of the voltage deviation variations by calculating the formula of "△dV1+△dV2+△dV3" and compare the calculated sum with the first criterion value (R1). In the embodiment of FIG. 4, since the calculated sum is equal to or greater than the first criterion value (R1), the control unit 120 may diagnose that an internal micro short circuit has occurred in the battery.

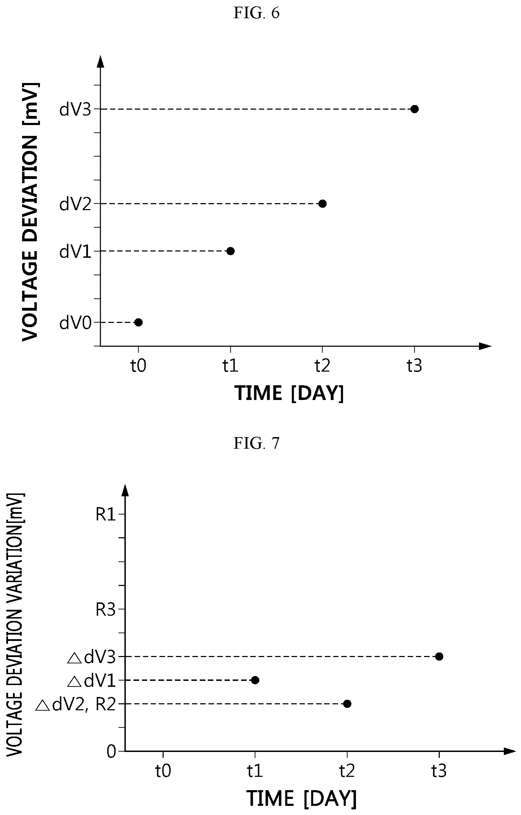

FIGS. 6 and 7 are diagrams schematically showing an embodiment of a second diagnosis pattern. Specifically, FIG. 6 is a diagram schematically showing an embodiment of the voltage deviation over time of the second diagnosis pattern. FIG. 7 is a diagram schematically showing an embodiment of the voltage deviation variation over time of the second diagnosis pattern based on the FIG. 6.

When the plurality of voltage deviation variations are greater than a preset second criterion value (R2), the control unit 120 may be configured to judge that the voltage deviation variation pattern corresponds to the second diagnosis pattern and diagnose that an internal micro short circuit has occurred in the battery.

For example, in the embodiment of FIG. 7, the first voltage deviation variation (△dV1), the second voltage deviation variation (△dV2), and the third voltage deviation variation (△dV3) may be positive numbers. Also, the magnitudes of the first voltage deviation variation (△dV1), the second voltage deviation variation (△dV2), and the third voltage deviation variation (△dV3) may be greater than or equal to the second criterion value (R2).

In one embodiment, the second criterion value (R2) may be set to a value less than the first criterion value (R1). For example, the first criterion value (R1) may be set to 10 mV, and the second criterion value (R2) may be set to 2 mV.

The control unit 120 may compare each of the first voltage deviation variation (△dV1), the second voltage deviation variation (△dV2), and the third voltage deviation variation (△dV3) with the second criterion value (R2). In the embodiment of FIG. 7, since the first voltage deviation variation (△dV1), the second voltage deviation variation (△dV2), and the third voltage deviation variation (△dV3) are all equal to or greater than the second criterion value (R2), the control unit 120 may diagnose that an internal micro short circuit has occurred in the battery.

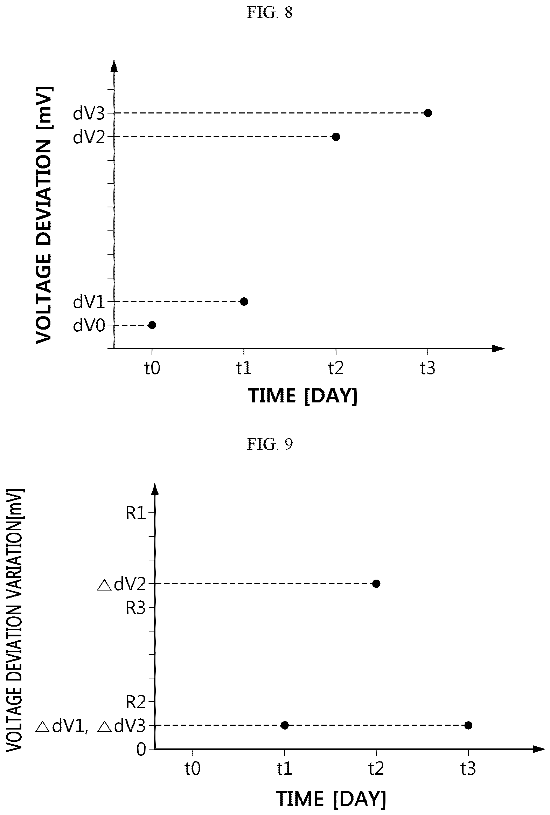

FIGS. 8 and 9 are diagrams schematically showing an embodiment of a third diagnosis pattern. Specifically, FIG. 8 is a diagram schematically showing an embodiment of the voltage deviation over time of the third diagnosis pattern. FIG. 9 is a diagram schematically showing an embodiment of the voltage deviation variation over time of the third diagnosis pattern based on the FIG. 8.

When the plurality of voltage deviation variations are positive numbers and at least one of the plurality of voltage deviation variations is greater than or equal to a preset third criterion value (R3), the control unit 120 may be configured to judge that the pattern of the voltage deviation variation corresponds to the third diagnosis pattern and diagnose that an internal micro short circuit has occurred in the battery.

For example, in the embodiment of FIG. 9, the first voltage deviation variation (△dV1), the second voltage deviation variation (△dV2), and the third voltage deviation variation (△dV3) may be positive numbers. In addition, the magnitude of the second voltage deviation variation (ΔdV2) among the first voltage deviation variation (△dV1), the second voltage deviation variation (△dV2), and the third voltage deviation variation (△dV3) may be greater than or equal to the third criterion value (R3). That is, the maximum magnitude of the first voltage deviation variation (△dV1), the second voltage deviation variation (△dV2), and the third voltage deviation variation (△dV3) may be greater than or equal to the third criterion value (R3).

In one embodiment, the third criterion value (R3) may be configured to be less than the preset first criterion value (R1) to correspond to the first diagnosis pattern, and to exceed the preset second criterion value (R2) to correspond to the second diagnosis pattern. For example, the first criterion value (R1) may be set to 10 mV, the second criterion value (R2) may be set to 2 mV, and the third criterion value (R3) may be set to 6 mV.

The control unit 120 may compare the maximum magnitude of the first voltage deviation variation (△dV1), the second voltage deviation variation (△dV2), and the third voltage deviation variation (△dV3) with the third criterion value (R3). In the embodiment of FIG. 9, since the second voltage deviation variation (△dV2) is greater than or equal to the third criterion value (R3), the control unit 120 may diagnose that an internal micro short circuit has occurred in the battery.

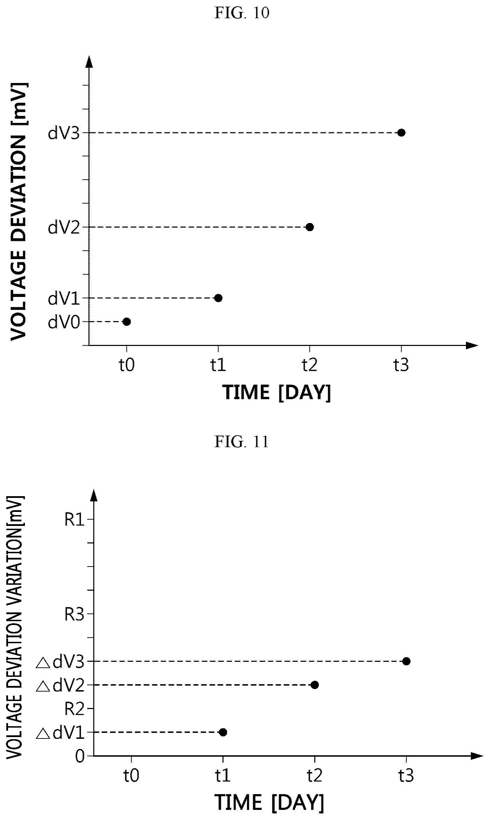

FIGS. 10 and 11 are diagrams schematically showing an embodiment of a fourth diagnosis pattern. Specifically, FIG. 10 is a diagram schematically showing an embodiment of the voltage deviation over time of the fourth diagnosis pattern. FIG. 11 is a diagram schematically showing an embodiment of the voltage deviation variation over time of the fourth diagnosis pattern based on the FIG. 10.

When the plurality of voltage deviation variations are positive numbers and the plurality of voltage deviation variations increase over time, the control unit 120 may be configured to judge that the pattern of the voltage deviation variation corresponds to the fourth diagnosis pattern and diagnose that an internal micro short circuit has occurred in the battery.

For example, in the embodiment of FIG. 11, the first voltage deviation variation (△dV1), the second voltage deviation variation (△dV2), and the third voltage deviation variation (△dV3) may be an increase pattern. That is, the first voltage deviation variation (△dV1), the second voltage deviation variation (△dV2), and the third voltage deviation variation (△dV3) may gradually increase over time (i.e., as time elapses in the order of time points t1, t2, and t3). For example, the first voltage deviation variation (△dV1) may be less than the second voltage deviation variation (△dV2), and the second voltage deviation variation (△dV2) may be less than the third voltage deviation variation (△dV3).

The control unit 120 may compare the magnitudes of the first voltage deviation variation (△dV1), the second voltage deviation variation (△dV2), and the third voltage deviation variation (△dV3) with each other to determine the pattern of the voltage deviation variation of the battery as an increase pattern. In the embodiment of FIG. 11, since the first voltage deviation variation (△dV1), the second voltage deviation variation (△dV2), and the third voltage deviation variation (△dV3) are an increase pattern, the control unit 120 may diagnose that an internal micro short circuit has occurred in the battery.

Meanwhile, the control unit 120 may be configured to diagnose that an internal micro short circuit has occurred in the battery if the pattern of the plurality of voltage deviation variations corresponds to any one of the diagnosis patterns.

In the embodiment of FIG. 5, the patterns of the plurality of voltage deviation variations (△dV1, △dV2, △dV3) may correspond to the first diagnosis pattern, but may not correspond to the second to fourth diagnosis patterns. For example, since the second voltage deviation variation (△dV2) is less than the second criterion value (R2), the patterns of the plurality of voltage deviation variations (△dV1, △dV2, △dV3) do not correspond to the second diagnosis pattern. In addition, since the maximum magnitude of the plurality of voltage deviation variations (△dV1, △dV2, △dV3) is less than the third criterion value (R3), the patterns of the plurality of voltage deviation variations (△dV1, △dV2, △dV3) do not correspond to the third diagnosis pattern. Also, since the second voltage deviation variation (△dV2) is smaller than the first voltage deviation variation (△dV1), the patterns of the plurality of voltage deviation variations (△dV1, △dV2, △dV3) do not correspond to the fourth diagnosis pattern.

In the embodiment of FIG. 7, the patterns of the plurality of voltage deviation variations (△dV1, △dV2, △dV3) may correspond to the second diagnosis pattern, but may not correspond to the first diagnosis pattern, the third diagnosis pattern, and the fourth diagnosis pattern. For example, since the sum of the first voltage deviation variation (△dV1), the second voltage deviation variation (△dV2) and the third voltage deviation variation (△dV3) is less than the first criterion value (R1), the patterns of the plurality of voltage deviation variations (△dV1, △dV2, △dV3) do not correspond to the first diagnosis pattern. In addition, since the maximum magnitude of the plurality of voltage deviation variations (△dV1, △dV2, △dV3) is less than the third criterion value (R3), the patterns of the plurality of voltage deviation variations (△dV1, △dV2, △dV3) do not correspond to the third diagnosis pattern. Also, since the second voltage deviation variation (△dV2) is smaller than the first voltage deviation variation (△dV1), the patterns of the plurality of voltage deviation variations (△dV1, △dV2, △dV3) do not correspond to the fourth diagnosis pattern.

In the embodiment of FIG. 9, the patterns of the plurality of voltage deviation variations (△dV1, △dV2, △dV3) may correspond to the third diagnosis pattern, but may not correspond to the first diagnosis pattern, the second diagnosis pattern, and the fourth diagnosis pattern. For example, since the sum of the first voltage deviation variation (△dV1), the second voltage deviation variation (△dV2) and the third voltage deviation variation (△dV3) is less than the first criterion value (R1), the patterns of the plurality of voltage deviation variations (△dV1, △dV2, △dV3) do not correspond to the first diagnosis pattern. In addition, since the first voltage deviation variation (△dV1) and the third voltage deviation variation (△dV3) are less than the second criterion value (R2), the patterns of the plurality of voltage deviation variations (△dV1, △dV2, △dV3) do not correspond to the second diagnosis pattern. In addition, since the third voltage deviation variation (△dV3) is smaller than the second voltage deviation variation (△dV2), the patterns of the plurality of voltage deviation variations (△dV1, △dV2, △dV3) do not correspond to the fourth diagnosis pattern.

In the embodiment of FIG. 11, the patterns of the plurality of voltage deviation variations (△dV1, △dV2, △dV3) may correspond to the fourth diagnosis pattern, but may not correspond to the first diagnosis pattern, the second diagnosis pattern, and the third diagnosis pattern. For example, since the sum of the first voltage deviation variation (△dV1), the second voltage deviation variation (△dV2) and the third voltage deviation variation (△dV3) is less than the first criterion value (R1), the patterns of the plurality of voltage deviation variations (△dV1, △dV2, △dV3) do not correspond to the first diagnosis pattern. In addition, since the first voltage deviation variation (△dV1) is less than the second criterion value (R2), the patterns of the plurality of voltage deviation variations (△dV1, △dV2, △dV3) do not correspond to the second diagnosis pattern. In addition, since the maximum magnitude of the plurality of voltage deviation variations (△dV1, △dV2, △dV3) is less than the third criterion value (R3), the patterns of the plurality of voltage deviation variations (△dV1, △dV2, △dV3) do not correspond to the third diagnosis pattern.

In an embodiments, the patterns of the plurality of voltage deviation variations (△dV1, △dV2, △dV3) may correspond to any one of the first to fourth diagnosis patterns. As such, if the patterns of the plurality of voltage deviation variations (△dV1, △dV2, △dV3) correspond to any one diagnosis pattern, the apparatus 100 for diagnosing a battery may diagnose that an internal micro short circuit has occurred in the battery. That is, the apparatus 100 for diagnosing a battery has an advantage of preventing a hard short from occurring in the battery in an unexpected situation by sensitively and strictly diagnosing the state of the battery.

In an embodiment, the control unit 120 may be configured to sequentially compare the patterns of the plurality of voltage deviation variations (△dV1, △dV2, △dV3) with the first to fourth diagnostic patterns. Specifically, the control unit 120 may sequentially compare the patterns of the plurality of voltage deviation variations (△dV1, △dV2, △dV3) with a first diagnostic pattern, a second diagnostic pattern, a third diagnostic pattern, and a fourth diagnostic pattern.

For example, the control unit 120 may confirm whether the patterns of the plurality of voltage deviation variations (△dV1, △dV2, △dV3) correspond to the first diagnosis pattern. If the patterns of the plurality of voltage deviation variations (△dV1, △dV2, △dV3) correspond to the first diagnosis pattern, the control unit 120 may diagnose that an internal micro short circuit has occurred in the battery.

If the patterns of the plurality of voltage deviation variations (△dV1, △dV2, △dV3) do not correspond to the first diagnosis pattern, the control unit 120 may confirm whether the patterns of the plurality of voltage deviation variations (△dV1, △dV2, △dV3) correspond to the second diagnosis pattern. If the patterns of the plurality of voltage deviation variations (△dV1, △dV2, △dV3) correspond to the second diagnosis pattern, the control unit 120 may diagnose that an internal micro short circuit has occurred in the battery.

If the patterns of the plurality of voltage deviation variations (△dV1, △dV2, △dV3) do not correspond to the second diagnosis pattern, the control unit 120 may confirm whether the patterns of the plurality of voltage deviation variations (△dV1, △dV2, △dV3) correspond to the third diagnosis pattern. If the patterns of the plurality of voltage deviation variations (△dV1, △dV2, △dV3) correspond to the third diagnosis pattern, the control unit 120 may diagnose that an internal micro short circuit has occurred in the battery.

If the patterns of the plurality of voltage deviation variations (△dV1, △dV2, △dV3) do not correspond to the third diagnosis pattern, the control unit 120 may confirm whether the patterns of the plurality of voltage deviation variations (△dV1, △dV2, △dV3) correspond to the fourth diagnosis pattern. If the patterns of the plurality of voltage deviation variations (△dV1, △dV2, △dV3) correspond to the fourth diagnosis pattern, the control unit 120 may diagnose that an internal micro short circuit has occurred in the battery.

If the patterns of the plurality of voltage deviation variations (△dV1, △dV2, △dV3) do not correspond to the fourth diagnosis pattern, the control unit 120 may diagnose that an internal micro short circuit has not occurred in the battery.

The battery diagnosis device 100 may diagnose whether an internal micro short circuit has occurred in the battery through a process of sequentially comparing the patterns of a plurality of voltage deviation changes (△dV1, △dV2, △dV3) with the first to fourth diagnosis patterns. While the preceding example describes sequentially comparing the patterns of the plurality of voltage deviation variations (△dV1, △dV2, △dV3) with the first to fourth diagnostic patterns, in some instances, the patterns of the plurality of voltage deviation variations may be compared in any order.

In one embodiment, when the plurality of voltage deviation variations are positive numbers, the control unit 120 may be configured to compare the pattern of the voltage deviation variations of the corresponding battery with a preset diagnosis pattern.

Specifically, the first to fourth diagnosis patterns may be based on the case where the plurality of voltage deviation variations are positive numbers. For example, the plurality of voltage deviation variations (△dV1, △dV2, △dV3) may all be positive numbers. That is, a battery with an internal micro short circuit may gradually increase its voltage deviation from other batteries as time passes. Accordingly, the control unit 120 may compare the patterns of the plurality of voltage deviation variations with the preset diagnosis pattern only for batteries in which the plurality of voltage deviation variations are all positive numbers in order to efficiently use system resources.

Based on determining an internal micro short circuit occurred within at least one battery, the apparatus 100 for diagnosing a battery may be configured to transmit a signal to an external device where the signal contains a diagnosis result of at least one battery. In an embodiment, the apparatus 100 for diagnosing a battery may transmit a plurality of signals where each signal contains a battery diagnosis result of each of the plurality of batteries. The external device may include at least one of an onboard vehicle system, an external vehicle system, one or more servers configured to communicate with a vehicle, or a mobile device configured to communicate with the vehicle.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the voltage measuring unit 110, the control unit 120 and the storage unit 130 of the apparatus 100 for diagnosing a battery may be implemented as components of the BMS.

In addition, the apparatus 100 for diagnosing a battery according to the present disclosure may be provided to a battery pack 10. That is, the battery pack 10 according to the present disclosure may include the above-described apparatus 100 for diagnosing a battery and one or more battery cells. In addition, the battery pack 10 may further include electrical components (a relay, a fuse and the like) and a case.

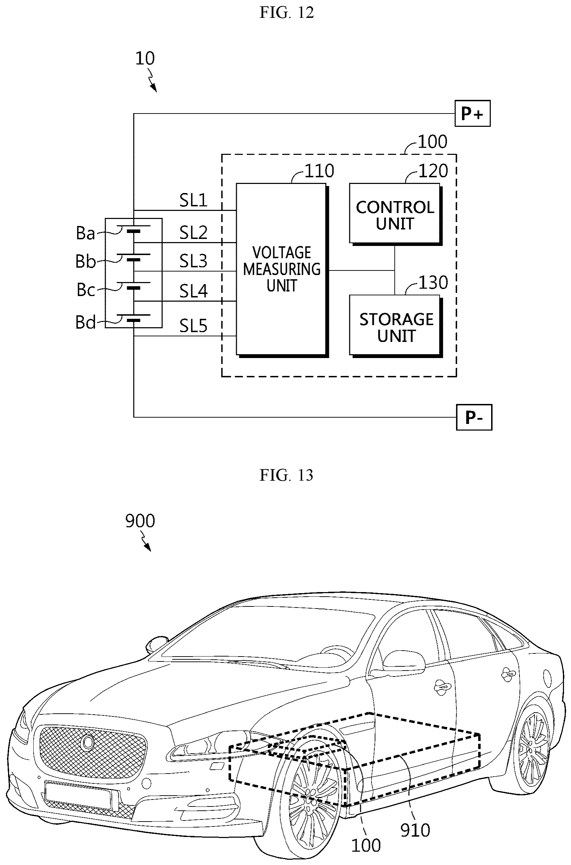

FIG. 12 is a diagram showing an exemplary configuration of a battery pack 10 according to another embodiment of the present disclosure. Preferably, the battery pack 10 may include the apparatus 100 for diagnosing a battery.

The battery pack 10 may include a first battery Ba, a second battery Bb, a third battery Bc, and a fourth battery Bd. For example, in the embodiment of FIG. 12, the first battery Ba, the second battery Bb, the third battery Bc, and the fourth battery Bd may be connected in series. It should be noted that the number of batteries included in the battery pack 10 and the connection relationship (serial and/or parallel) of the batteries are not limited by the embodiment of FIG. 8.

The positive electrode terminal of the first battery Ba may be connected to the positive electrode terminal P+ of the battery pack 10, and the negative electrode terminal of the fourth battery Bd may be connected to the negative electrode terminal P- of the battery pack 10.

The voltage measuring unit 10 may be connected to the first sensing line SL1, the second sensing line SL2, the third sensing line SL3, the fourth sensing line SL4 and the fifth sensing line SL5.

Specifically, the voltage measuring unit 110 may be connected to the positive electrode terminal of the first battery Ba through the first sensing line SL1, and may be connected to the negative electrode terminal of the first battery Ba through the second sensing line SL2. The voltage measuring unit 110 may measure the voltage of the first battery Ba based on the voltage measured at each of the first sensing line SL1 and the second sensing line SL2.

Similarly, the voltage measuring unit 110 may measure the voltage of the second battery Bb through the second sensing line SL2 and the third sensing line SL3, measure the voltage of the third battery Bc through the third sensing line SL3 and the fourth sensing line SL4, and measure the voltage of the fourth battery Bd through the fourth sensing line SL4 and the fifth sensing line SL5.

An external device may be connected to the positive terminal P+ and the negative terminal P- of the battery pack 10. For example, the external device may be a motor of an electric vehicle receiving power from the battery pack 10. As another example, the external device may be a charging device for charging the battery pack 10.

FIG. 13 is a diagram schematically showing a vehicle 900 according to still another embodiment of the present disclosure.

Referring to FIG. 13, a battery pack 910 according to an embodiment of the present disclosure may be included in a vehicle 900 such as an electric vehicle (EV) or a hybrid vehicle (HV). In addition, the battery pack 910 may drive the vehicle 900 by supplying power to a motor through an inverter included in the vehicle 900. In addition, the battery pack 910 may include the apparatus 100 for diagnosing a battery according to an embodiment of the present disclosure.

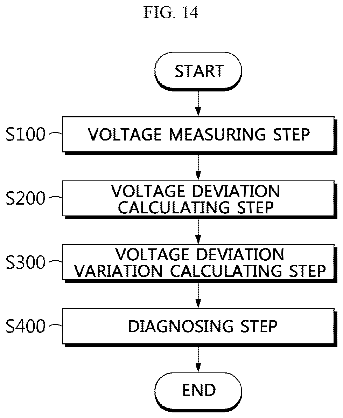

FIG. 14 is a diagram schematically showing a method for diagnosing a battery according to still another embodiment of the present disclosure.

Preferably, each step of the method for diagnosing a battery may be performed by the apparatus 100 for diagnosing a battery. Hereinafter, for convenience of explanation, the content overlapping with the previously described content will be omitted or briefly described.

The voltage measuring step (S100) is a step of measuring voltages of a plurality of batteries, and may be performed by the voltage measuring unit 110.

For example, the voltage measuring unit 110 may measure the voltage of each of the plurality of batteries.

In the embodiment of FIG. 2, the voltage measuring unit 110 may measure voltages of a first battery Ba, a second battery Bb, a third battery Bc, and a fourth battery Bd as Va, Vb, Vc, and Vd.

The voltage deviation calculating step (S200) is a step of calculating a voltage deviation of the plurality of batteries, and may be performed by the control unit 120.

For example, the control unit 120 may calculate an average voltage of the plurality of batteries. In addition, the control unit 120 may calculate a voltage deviation of each of the plurality of batteries by calculating a difference between the calculated average voltage and the voltage of each of the plurality of batteries.

In the embodiment of FIG. 2, the control unit 120 may calculate the average voltage of the first battery Ba, the second battery Bb, the third battery Bc, and the fourth battery Bd as Vavg. The control unit 120 may calculate the voltage deviations of the first battery Ba, the second battery Bb, the third battery Bc, and the fourth battery Bd as dVa , dVb, dVc and dVd, respectively, by calculating the difference between the voltage of the first battery Ba, the second battery Bb, the third battery Bc, and the fourth battery Bd and the average voltage.

The voltage deviation variation calculating step (S300) is a step of calculating a voltage deviation variation of each of the plurality of batteries at each predetermined period, and may be performed by the control unit 120.

For example, the control unit 120 may calculate a variation between the voltage deviations calculated at each predetermined period for each of the plurality of batteries.

In the embodiment of FIG. 3, the control unit 120 may calculate the voltage deviation variation of the first battery Ba as △dV1, △dV2, and △dV3 at time points t1, t2, and t3.

The diagnosing step (S400) is a step of diagnosing the state of each of the plurality of batteries by comparing a pattern of the voltage deviation variation of each of the plurality of batteries with a preset diagnosis pattern, and may be performed by the control unit 120.

For example, the control unit 120 may be configured to diagnose the state of a corresponding battery by analyzing the pattern of a plurality of voltage deviation variations calculated for each battery.

In the embodiment of FIG. 3, the control unit 120 may determine a diagnosis pattern to which the pattern of the voltage deviation variations (△dV1, △dV2, △dV3) belongs among preset diagnosis patterns. Also, the control unit 120 may diagnose the state of the first battery Ba to correspond to the determined diagnosis pattern.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

A method according to an embodiment of the present disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

10: battery pack
100: apparatus for diagnosing a battery
110: voltage measuring unit
120: control unit
130: storage unit
900: vehicle
910: battery pack
Ba: first battery
Bb: second battery
Bc: third battery
Bd: fourth battery

Further embodiments are described in the following numbered paragraphs:
1. An apparatus for diagnosing a battery, comprising:
   a voltage measuring unit configured to measure voltages of a plurality of batteries; and
   a control unit configured to calculate a voltage deviation of the plurality of batteries, calculate a voltage deviation variation of each of the plurality of batteries at each predetermined period, and compare a pattern of the voltage deviation variation of each of the plurality of batteries with a preset diagnosis pattern to diagnose a state of each of the plurality of batteries.
2. The apparatus for diagnosing a battery according to paragraph 1,
   wherein the control unit is configured to diagnose a state of a corresponding battery based on at least one of sum, magnitude and increase pattern of a plurality of voltage deviation variations calculated at a plurality of time points for each of the plurality of batteries.
3. The apparatus for diagnosing a battery according to paragraph 2,
   wherein the diagnosis pattern includes at least one of a first diagnosis pattern corresponding to the sum of the plurality of voltage deviation variations, a second diagnosis pattern corresponding to the magnitude of each of the plurality of voltage deviation variations, a third diagnosis pattern corresponding to the maximum magnitude of the plurality of voltage deviation variations, and a fourth diagnosis pattern corresponding to the increase pattern of the plurality of voltage deviation variations.
4. The apparatus for diagnosing a battery according to paragraph 3,
   wherein the control unit is configured to diagnose that an internal micro short circuit has occurred in the battery when the pattern of the plurality of voltage deviation variations corresponds to at least one of the diagnosis patterns.
5. The apparatus for diagnosing a battery according to paragraph 3,
   wherein when the plurality of voltage deviation variations are positive numbers and the sum of the plurality of voltage deviation variations is greater than or equal to a preset first criterion value, the control unit is configured to judge that the pattern of the voltage deviation variation corresponds to the first diagnosis pattern and diagnose that an internal micro short circuit has occurred in the battery.
6. The apparatus for diagnosing a battery according to paragraph 3,
   wherein when the plurality of voltage deviation variations are greater than or equal to a preset second criterion value, the control unit is configured to judge that the pattern of the voltage deviation variation corresponds to the second diagnosis pattern and diagnose that an internal micro short circuit has occurred in the battery.
7. The apparatus for diagnosing a battery according to paragraph 3,
   wherein when the plurality of voltage deviation variations are positive numbers and at least one of the plurality of voltage deviation variations is greater than or equal to a preset third criterion value, the control unit is configured to judge that the pattern of the voltage deviation variation corresponds to the third diagnosis pattern and diagnose that an internal micro short circuit has occurred in the battery.
8. The apparatus for diagnosing a battery according to paragraph 7,
   wherein the third criterion value is configured to be less than a preset first criterion value to correspond to the first diagnosis pattern and to exceed a preset second criterion value to correspond to the second diagnosis pattern.
9. The apparatus for diagnosing a battery according to paragraph 3,
   wherein when the plurality of voltage deviation variations are positive numbers and the plurality of voltage deviation variations increase over time, the control unit is configured to judge that the pattern of the voltage deviation variation corresponds to the fourth diagnosis pattern and diagnose that an internal micro short circuit has occurred in the battery.
10. The apparatus for diagnosing a battery according to paragraph 2,
   wherein when the plurality of voltage deviation variations are positive numbers, the control unit is configured to compare the pattern of the voltage deviation variation of the corresponding battery with a preset diagnosis pattern.
11. The apparatus for diagnosing a battery according to paragraph 1,
   wherein the control unit is configured to calculate an average voltage of the plurality of batteries and calculate a voltage deviation of each of the plurality of batteries by calculating a difference between the calculated average voltage and the voltage of each of the plurality of batteries.
12. The apparatus for diagnosing a battery according to paragraph 1,
   wherein the control unit is configured to transmit at least one signal to an external device, the signal containing a diagnosis result of each of the plurality of batteries, and
   wherein the external device corresponds to any one of an onboard vehicle system, an external vehicle system, one or more servers configured to communicate with a vehicle, or a mobile device configured to communicate with the vehicle.
13. A battery pack comprising the apparatus for diagnosing a battery according to any one of paragraphs 1 to 12.
14. A vehicle comprising the apparatus for diagnosing a battery according to any one of paragraphs 1 to 12.
15. A method for diagnosing a battery, comprising:
   a voltage measuring step of measuring voltages of a plurality of batteries;
   a voltage deviation calculating step of calculating a voltage deviation of the plurality of batteries;
   a voltage deviation variation calculating step of calculating a voltage deviation variation of each of the plurality of batteries at each predetermined period; and
   a diagnosing step of comparing a pattern of the voltage deviation variation of each of the plurality of batteries with a preset diagnosis pattern to diagnose a state of each of the plurality of batteries.

## Claims

1. An apparatus for diagnosing a battery, comprising:
one or more processors configured to:
obtain voltages of a plurality of batteries,
calculate a first voltage deviation of the battery, from among the plurality of batteries, based on a voltage of the battery obtained at a first time point and a first average voltage calculated based on the voltages obtained at the first time point,
calculate a second voltage deviation of the battery based on a voltage of the battery obtained at a second time point and a second average voltage calculated based on the voltages obtained at the second time point,
calculate a voltage deviation variation of the battery based on the first and second voltage deviations, and
diagnose the battery based on the voltage deviation variation.

2. The apparatus of claim 1,
wherein the one or more processors are configured to diagnose a state of the battery of the plurality of batteries based on at least one of a sum, a magnitude, or a pattern of voltage deviation variations of the battery.

3. The apparatus of claim 2,
wherein the one or more processors are configured to compare the pattern of the voltage deviation variations of the battery with a preset diagnosis pattern to diagnose the state of the battery.

4. The apparatus of claim 3, wherein the preset diagnosis pattern corresponds to at least one of:
a first diagnosis pattern corresponding to the sum of the voltage deviation variations within the pattern of the voltage deviation variations;
a second diagnosis pattern corresponding to the magnitude of each of the voltage deviation variations;
a third diagnosis pattern corresponding to a maximum magnitude of the voltage deviation variations; or
a fourth diagnosis pattern corresponding to an increase pattern of the voltage deviation variations.

5. The apparatus of claim 4,
wherein the one or more processors are configured to diagnose that an internal micro short circuit has occurred in the battery when the pattern of voltage deviation variations corresponds to at least one of the diagnosis patterns.

6. The apparatus of claim 4,
wherein the first diagnosis pattern comprises the one or more processors determining that when the voltage deviation variations are positive numbers and the sum of the voltage deviation variations is greater than or equal to a first preset criterion value, an internal micro short circuit has occurred in the battery.

7. The apparatus of claim 4,
wherein the second diagnosis pattern comprises the one or more processors determining that when the voltage deviation variations are greater than or equal to a second preset criterion value, an internal micro short circuit has occurred in the battery.

8. The apparatus of claim 4,
wherein the third diagnosis pattern comprises the one or more processors determining that when the voltage deviation variations are positive numbers and at least one of the voltage deviation variations is greater than or equal to a third preset criterion value, an internal micro short circuit has occurred in the battery.

9. The apparatus of claim 8,
wherein the third preset criterion value is configured to be less than a first preset criterion value that corresponds to the first diagnosis pattern and to be greater than a second preset criterion value that corresponds to the second diagnosis pattern.

10. The apparatus of claim 4,
wherein the fourth diagnosis pattern comprises the one or more processors determining that when the voltage deviation variations are positive numbers and the pattern of voltage deviation variations increases over time, an internal micro short circuit has occurred in the battery.

11. The apparatus of claim 1,
wherein the one or more processors are configured to calculate a voltage deviation of the battery based on the calculated average voltage and the voltage of the battery.

12. The apparatus of claim 1, wherein the external device corresponds to one of an onboard vehicle system, an external vehicle system, one or more servers configured to communicate with a vehicle, or a mobile device configured to communicate with the vehicle.

13. A battery pack comprising the apparatus for diagnosing a battery according to any one of claims 1 to 12.

14. A vehicle comprising the apparatus for diagnosing a battery according to any one of claims 1 to 12.

15. A method for diagnosing a battery, comprising:
obtaining voltages of a plurality of batteries;
calculating a first voltage deviation of the battery, from among the plurality of batteries, based on a voltage of the battery obtained at a first time point and a first average voltage calculated based on the voltages obtained at the first time point;
calculating a second voltage deviation of the battery based on a voltage of the battery obtained at a second time point and a second average voltage calculated based on the voltages obtained at the second time point;
calculating a voltage deviation variation of the battery based on the first and second voltage deviations; and
diagnosing the battery based on the voltage deviation variation.

16. The method of claim 15, further comprising comparing the voltage deviation variations of the battery with a preset diagnosis pattern to diagnose a state of the battery, wherein the preset diagnosis pattern corresponds to at least one of:
a first diagnosis pattern corresponding to a sum of the voltage deviation variations within a pattern of the voltage deviation variations;
a second diagnosis pattern corresponding to a magnitude of each of the voltage deviation variations;
a third diagnosis pattern corresponding to a maximum magnitude of the voltage deviation variations; or
a fourth diagnosis pattern corresponding to an increase pattern of the voltage deviation variations.

17. The method of claim 15, further comprising diagnosing a state of the battery based on at least one of a sum, a magnitude, or a pattern of voltage deviation variations of the battery.

18. The method of claim 15, wherein the external device corresponds to one of an onboard vehicle system, an external vehicle system, one or more servers configured to communicate with a vehicle, or a mobile device configured to communicate with the vehicle.

19. The method of claim 16, further comprising diagnosing that an internal micro short circuit has occurred in the battery when the pattern of voltage deviation variations corresponds to at least one of the diagnosis patterns.

20. A computer-readable medium storing computing instructions that, when executed by one or more processors, cause the one or more processors to perform:
obtaining voltages of a plurality of batteries;
calculating a first voltage deviation of the battery, from among the plurality of batteries, based on a voltage of the battery obtained at a first time point and a first average voltage calculated based on the voltages obtained at the first time point;
calculating a second voltage deviation of the battery based on a voltage of the battery obtained at a second time point and a second average voltage calculated based on the voltages obtained at the second time point;
calculating a voltage deviation variation of the battery based on the first and second voltage deviations; and
diagnosing the battery based on the voltage deviation variation.
